# EUROPEAN PATENT SPECIFICATION

(11) **EP 0 428 503 B1**
(45) Date of publication and mention of the grant of the patent: **20.09.1995**
(21) Application number: 91101263.1
(22) Date of filing: 28.11.1986
(51) Int. Cl.: H03K 19/177

(54) **Programmable logic device with programmable output selection means**
Programmierbare logische Schaltung mit konfigurierbarer Freigabe des Ausgangs
Dispositif logique programmable avec validation configurable de la sortie

(30) Priority: 06.12.1985 US 806158
(43) Date of publication of application: 22.05.1991
(62) Divisional of application: 86309319.1
(73) Proprietor: ADVANCED MICRO DEVICES, INC., Sunnyvale, CA 94088-3453 (US)
(72) Inventor: Agrawal, Om P., San Jose, California 95148 (US); Shankar, Kapil, 128-3 San Jose, California 95127 (US); Mubarak, Fares, 1 San Jose, California 95117 (US)
(74) Representative: Wright, Hugh Ronald

(56) References cited:
- WESCON TECHNICAL PAPERS, 30th October - 2nd November 1984, pages 1-6, Anaheim, California, Los Angeles, US; Y.-F. CHAN: "Programmable logic replaces gate arrays"
- ELECTRO AND MINI/MICRO NORTHEAST, 23rd - 25th April 1985, pages (II/3)1-6, New York, US; S.A. KAZMI: "Implementing custom designs with erasable programmable logic devices"
- WESCON TECHNICAL PAPERS, 30th October - 2nd November 1984, pages (19/1)1-6,Anaheim, California, Los Angles, US; J.YEE: "Second-generation programmable logic devices extend design capabilities"

## Description

The present invention relates to integrated circuit chips, and more particularly, to integrated circuits containing programmable logic devices having embedded and observable internal state registers. especially one containing a programmable AND and OR array logic devices. Reference is made to our copending European Patent Application 86308372, published as EP-A-0 225 715.

As the technology for manufacturing integrated circuits progresses, it is becoming possible to put more and more discrete logic components on a single integrated circuit chip. For instance, there can be thousands of discrete logic components, such as, AND-gates, OR-gates, inverters and registers, on a single integrated circuit chip. However, due to limitations in packaging technology, the number of input and output ports to a given integrated circuit chip is limited. Thus, thousands of discrete logic components must be served typically by on the order of a few dozen input/output (I/O) ports. The small number of input/output ports available for a given integrated circuit thus severely restricts the flexibility in design of logic circuits implemented on integrated circuit chips.

Flexibility in design is particularly important for devices such as programmable array logic devices. In a programmable array logic device, a user of the device configures the logic array according to a specific need using field programming techniques. Since the user is constrained in his design choices by the configuration of the input/output pins, the utility of the programmable logic array is limited.

Our European Patent Specification 86308372 addresses one way in which the configuration of input/output ports may be made more flexible. There, the user is able to select from a variety of input modes or a variety of output modes for a given input/output pin by setting a selector means using field programming techniques, such as blowing a fuse or not blowing the fuse, when the designer sets up the logic circuit on the chip in conjunction with user-determined "product terms" generated within the logic array. In the input mode the port may be configured as a dedicated, registered, or latched input; in the output mode as registered, combinatorial or latched output. A register/latch, in conjunction with a fuse-programmable input select multiplexer, can function as an input, output or buried register or as a transparent latch. A programmable clock select multiplexer selects between a clock/latch enable signal applied at an external pin or a product term generated internally. Clock polarity control is also provided. Asynchronous reset and preset of the register/latch is provided along with polarity control therefor. Dedicated and programmable feedback paths are provided. An output inverter can selectably be enabled from internal signals or from an external pin. The input/output circuit can be deployed in banks, each bank selectably receiving the same or a different clock. The register/latch can be preloaded via an internally-generated signal or from the external pins. Thus, for example, the designer is able to locate registered outputs and combinatorial outputs on the I/O pins as he desires for a selected logic array package.

Another way in which to increase the flexibility of the design for programmable array logic devices of the prior art provides selectable feedback in the output logic so that the designer may choose using field programming techniques to provide a feedback path directly from the I/O pin to the logic array, in effect, treating the I/O pin as an input pin, or to select a registered output from the logic array as feedback. This sort of feedback system is described in product literature for the Advanced Micro Devices 24-pin IMOX™ Programmable Array Logic Device designated the AmPAL22V10 (PAL is a registered trademark of Monolithic Memories, Inc.). An advanced information sheet concerning the AMPAL22V10 was released by Advanced Micro Devices, Inc., Sunnyvale, California dated June, 1983. This advanced information can be referred to for further background to the present invention.

Both the output selector and the feedback selector of the prior art mentioned above involved a designed-in or field programmed selection of the type of feedback or the type of output for a particular I/O pin. Accordingly, the user was limited to one configuration of each I/O pin for the device. Since it is desirable to provide a flexible output logic circuit, there is a need for an output logic circuit which provides for increased flexibility and overcomes the limitations of the prior art.

Furthermore, because of the use of such logic circuits in sequencers which employ internal state counters, it is often desirable to deploy a register within the logic circuit as a dedicated buried state register. Accordingly, there is need for an input/output circuit which can be flexibly configured in which a so-called "buried", or internal, state register can be flexibly utilized. This feature allows the system designer to build improved "state machines" or "control sequencers" as they are known. A need for monitoring the contents of these registers is also recognized as a desirable feature missing from input/output logic circuits.

Another limitation in the prior art is the lack of observable buried state registers with a variable number of "product terms" received by an OR gate supplying each register and a lack of dedicated feedback paths from all I/O pins to the logic circuitry internal to the chip. As such, undesirable design constraints are imposed in the manner in which signals generated internally are allocated, oftentimes resulting in inefficient use of registers. For instance, existing programmable array logic devices typically have ten or twelve registers, each allocated an I/O pin. A state machine designer using such a device is forced to allocate some of these registers as internal state registers, thereby tying up scarce I/O pins. It is desirable that a number of user-accessible, dedicated internal state registers be available which are not allocated an I/O pin. However, mere provision of such accessible registers is not sufficient because a circuit must be tested by the designer. This requires dynamically observing the contents of these internal state registers during debugging and circuit verification.

Further, while the prior art provides dedicated feedback, for the determination of states, from the registers allocated an I/O pin, a designer would like to permit the stage to be a function of the contents of all registers, including the internal state registers, Accordingly, it would be desirable to have dedicated feedback from all registers, so that the designer can flexibly construct a state machine with a variable number of internal states and a variable number of registers allocated an I/O pin.

Frequently, registers within programmable array logic devices are used as "state machine" counters and, normally, the contents of such registers need not be conducted to I/O pins, since their contents is used internally for counting purposes. However, the prior art has nevertheless allocated an I/O pin to each of such registers for such PAL "logic sequencers," as they are called. A further need develops during the preliminary testing and development of the input/output circuit for observing the contents of such buried state registers while not dedicating an input/output pin for this purpose.

A further desirable feature is the ability to preload registers from the logic array, rather than applying a Zener level preload voltage, which may not be available during testing stages.

Provision of an independent combinatorial signal from a programmable OR portion of the logic array, separate from the signal received therefrom and stored in a register, is desirable in that the register may be used as a buried register when the signal received independently from the array is conducted to the I/O pin serving this register. This capability also allows the designer a different combinatorial and a different sequential output to be fedback from the same device, by selecting the output appropriately.

Furthermore, it is often desirable to allow clocking of the register of individual output logic circuits from the logic array as well as from the usual clock, with selection by the user. It may even be desirable to permit user-selection from a pair of clocks, particularly when the integrated circuit chips employing the output logic circuits are deployed in two banks, each with its own clock.

Reference may be made to WESCON TECHNICAL PAPERS 30 October-2 November 1984, pages (19/1) 1-6 by J. YEE which describes an arrangement generally corresponding to the introduction to claim 1.

Accordingly the present invention provides a programmable logic device including:
a logic array which is arranged to generate, from a number of input signals, a plurality of output signals which may be data signals and/or control signals,
a plurality of output cells each comprising a storage cell arranged to store a first data signal generated as a first array output by said logic array and present it at a cell output, and an input/output port
characterised in that:
programmable means is provided responsive to a first selection signal to selectively connect the input/output port of an output cell to either the output of the storage cell or to a second, separate, data signal generated as a second array output by said logic array.

### BRIEF DESCRIPTION OF THE DRAWINGS

Fig. 1 is a logic diagram of a programmable array logic device.

Fig. 2 is a logic diagram of a programmable array logic device employing dual clocks.

Fig. 3 is a logic diagram of an embodiment of an output macrocell of the present invention.

### DETAILED DESCRIPTION OF THE PREFERRED EMBODIMENTS

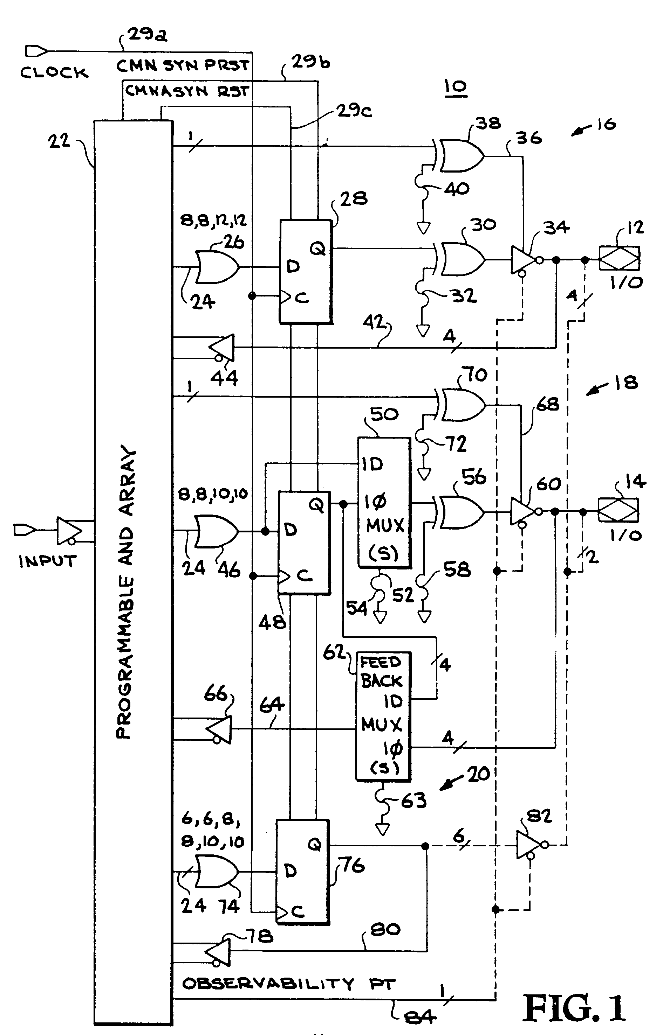

Fig. 1 is a logic diagram of the programmable array logic (PAL) device 10. The PAL 10 as shown in Fig. 1 permits configuration of the input/output ports of an integrated circuit ship, such as input/output (I/O) pins 12 and 14. For purposes of illustration, only one, 12, of the several, such as four, I/O pins is shown, which serve the several, such as four, dedicated output register portions only one, 16, of which is shown. Similarly, only one, 14, of the several, such as four, I/O pins is shown, which serve the several, such as four, output macro cells 18. Also, only one, 20, of the several, such as six, buried state register portions is shown in Fig. 1.

The PAL device 10 is connected to a programmable AND array 22, which generates combinatorial logic signals on a set of lines 24. The construction of the programmable AND array 22 is discussed in more detail below. As appreciated in the art, other means for dynamically providing the control signals in this invention can be used, such as a combination of logic signals from a plurality of programmable AND arrays. The lines 24 conduct the logic signals generated by AND array 22 to OR gates serving the dedicated output register portions 16, the output macro cells 18 and the buried state register portions 20. A variable number of lines 24 is connected to each of the various OR gates so as to provide a variable distribution of signals to more efficiently utilize the AND array 22. The numbers adjacent to the lines 24 at their terminus on the OR gates shown in Fig. 1 indicate the number of lines terminating on a particular one of the OR gates serving the four output register portions 16, the four output macro cells 18, and the six buried state register portions 20. Various other signal lines shown in Fig. 1 also have numbers adjacent to them which similarly indicate the number of signals conducted in parallel between the elements interconnected by the signal line.

These signals, also called "product terms", are conducted on lines 24 to an OR gate 26 serving the particular dedicated output register portion 16 shown in Fig. 1. Further description of these so-called "product terms" is also contained hereinafter. OR gate 26 is connected to a data (D) input of a register 28. Responsive to a clock (CLK) signal on line 29 received at a clock (C) input of register 28 generates a signal at a Q output terminal thereof. Alternatively, the state of register 28 may be set by application of a common synchronous preset (CMN SYN PRST) signal received from the AND array 22 via a signal line 29b or a common asynchronous reset (CMN ASYN RST) signal received from the AND array 22 via a signal line 29C. A fuse-programmable exclusive OR (XOR) output polarity control gate 30 receives at a first input the signal generated by register 28. A second input of XOR gate 30 is connected to a field-programmable fuse 32, the status of which determines the polarity of the signal generated by dedicated output register portion 16.

Each field-programmable fuse circuit includes a resistor (not shown) connected to a high potential V_{cc}. In parallel with the resistor is a fuse connected to ground. The fuse is a field programmable fuse which may be blown or not blown as the user desires when he sets up the device to choose various features such as input selection and clock polarity. Means for dynamically providing control signals can be implemented, instead of by the static field-programmable input, by the product terms generated by programmable AND arrays, a combination of programmable AND arrays, or the like. Further, it will be appreciated by those skilled in the art that the control signals determined by the state elements shown in the figures, and described herein, as field-programmable fuses, may be alternatively provided by CMOS, EPROM or E²PROM memory elements or by signals applied to external pins of the integrated circuit.

The dedicated output register portion 16 also includes an output inverting buffer 34 which receives the output signal generated by output polarity control gate 30. The output inverting buffer 34 is enabled by an output enable signal received on line 36. A product term is conducted from the programmable AND array 22 to a first input of a fuse-programmable output enable polarity control XOR gate 38. A second input of XOR gate 38 is connected to a field-programmable fuse 40, the status of which determines the polarity of the output enable signal received by buffer 34. The signal generated by buffer 34 is conducted to I/O pin 12 and via a feedback circuit path 42 from the I/O pin 12 directly to a true and complement buffer 44. The signals generated at the output terminals of input buffer 44 are conducted to the AND array 22.

Other product terms are conducted on lines 24 from AND array 22 to an OR gate 46 serving the particular output macro cell 18 shown in Fig. 1. OR gate 46 is connected to the data input (D) of a register 48. Responsive to the clock (CLK) signal on line 29a, the register 48 generates a signal at a Q output terminal. Alternatively, the state of register 48 may be set by application of the CMN SYN PRST or CMN ASYN RST signals received from the programmable AND array via lines 29b and 29c. The asynchronous reset signal will cause the register 28 to generate a logic ZERO output signal at its Q output terminal when the common asynchronous reset signal CMN ASYN RST goes HIGH. This switching occurs independent of the CLK signal applied to register 28. When the common synchronous preset signal CMN SYN PRST is set, the signal generated at the Q output of the register 28 is set to a HIGH signal when clocked by the CLK signal received by register 28. Means providing the synchronous preset signal CMN SYN PRST or asynchronous reset signal CMN ASYN RST are not shown in Fig. 1, but can be implemented dynamically using various product terms generated by the programmable AND array 22 or the like.

The output macrocell portion 18 shown in Fig. 1 further includes an output select 2 to 1 multiplexer 50, which receives the signal generated by register 48 at a 10 input terminal and the signal generated by OR gate 46 at a 1D input terminal.

The output select multiplexer (MUX) 50 generates at an output terminal either the signal applied at its 1D or the signal applied at its 10 input terminal depending on the state of the signal applied to an output control select input S as provided over line 52. A field-programmable fuse 54 is connected to line 52 which determines the state of the output select signal applied to input S. The fuse 54 connected to input S determines the "output selection". A fuse-programmable XOR gate 56 receives at a first input the signal generated by MUX 50 and a fuse 58 connected to a second input of gate 56 determines the "output polarity" of the signal generated by output macrocell 18 and conducted to an inverting output buffer 60.

Included in the output macrocell 18 of Fig. 1 is a fuse-programmable two input/one output feedback multiplexer (MUX) 62. The feedback MUX 62 receives at a 1D input terminal the logic signal generated by the inverting buffer 60 or received from the I/O pin 14. MUX 62 receives at a 10 input terminal the signal generated at the Q output terminal of register 48.

The feedback MUX 62 generates at its output terminal one of the signals applied to its 1D or 10 terminals as controlled by the field-programmable fuse 63 connected to a control select input (Sₒ) of MUX 62. Thus in response to a feedback select control signal applied to the S0 terminal, the feedback MUX 62 selects from the signals applied to its 1D or 10 input terminals to generate a feedback signal on line 64. The feedback signal on line 64 is conducted to an input buffer such as the true and complement buffer 66 for feedback to the logic circuits internal to the AND array 22 of the integrated circuit.

The output inverting buffer 60 is enabled by an output enable signal received on line 68. A product term is conducted from the programmable AND array 22 to a first input of a fuse-programmable output enable polarity control XOR gate 70. A second input of XOR gate 70 is connected to a field-programmable fuse 72, the status of which determines the polarity of the output enable signal received by buffer 60. The signal generated by buffer 60 is conducted to I/O pin 14.

Other product terms are conducted on lines 24 from AND array 22 to an OR gate 74 serving the particular buried state register portion 20 shown in Fig. 1. OR gate 74 is connected to the data input (D) of a so-called "buried" register 76. Responsive to the clock (CLK) on line 29a, the buried register 76 generates a signal at its Q output terminal. Alternatively, the state of register 76 may be set by application of the CMN SYN PRST or CMN ASYN RST signals received on lines 29b and 29c.

The signal generated by buried register 76 is conducted to a true and complement buffer 78 on a feedback signal path 80 and therefrom to the programmable AND array 22. The signal generated by register 76 is also conducted to an inverting output buffer 82 which receives a user-determinable OBSERVABILITY product term signal from the AND array 22 via a signal line 84. Output buffers 34 and 60 also receive the OBSERVABILITY signal at a complemented input.

Buffers 34 and 60 can be enabled by the output enable signals received on lines 36 and 68, respectively, to conduct signals generated from the dedicated output register portion 16 and from the output macrocell 18, respectively, to the I/O pins 12 and 14, respectively. Alternatively, the buffers 34 and 60 can be disabled by the OBSERVABILITY signal received on line 84 and the buffer 82 can be enabled by the OBSERVABILITY signal so as to conduct signals generated from the buried state register portion 20 of the PAL device 10 the the I/O pine 12 or the I/O pine 14. The OBSERVABILITY product term signal accordingly suppresses the selection of the normal output signals and allows observation of the contents of the buried state registers at the I/O pins 12 and 14.

As mentioned earlier, the control of any of the circuit elements shown on Fig. 1 by means of the programmable fuses 32, 40, 54, 58, 63 and 72 can be alternately provided by product terms generated by the circuits internal to the integrated circuit chip containing circuit 10. Another alternative is to control any of these elements by signal applied to the external terminals (pins) of the integrated circuit chip, as will be appreciated by those skilled in the art.

The programmable AND array 22 shown in Fig. 1 is constructed using the sum of products scheme familiar to those skilled in the art, although other combinations of logic cells can be used. Reference can be had to "Programmable Array Logic Handbook" copyright l984, Advanced Micro Devices, Inc. and to the related, copending application entitled "Programmable Input/Output Cell with Flexible Clocking and Flexible Feedback" for further details of the internal construction of PALs.

As shown on Fig. 1, the logic signal on lines 24 are provided as a sum-of-product term combinatorial signal to the OR-gates 26, 46 and 74. In Fig. 1, these three OR-gates are shown receiving signals from a variable number of separate programmable AND gates within array 22 to provide the combinatorial signal received by the registers 28, 48 and 76, respectively. However, as is appreciated in the art, any number of programmable AND gates can be designed as an input to the OR-gates to provide this combinatorial signal.

In Fig. 1, a clock is connected to an input pin providing a clock signal on line 29a.

Each of the dynamic control signals discussed with reference to Fig. 1, are provided as the output of the single programmable AND array 22. Accordingly, the common asynchronous reset signal (CMN ASYN RST) and the common synchronous preset signal (CMN SYN PRST) are provided as the output of the programmable AND array on lines 29c and 29b, respectively. The observability signal is provided as the output of a programmable AND array on line 84. The various output enable signals are provided as the output of the programmable AND array on signal lines connected to XOR gates 38 and 70. Any of the control signals mentioned above can be implemented by more complicated logic circuitry, such as sum-of-products terms, if desired.

The means providing the various dynamic control signals can be configured in a variety of manners, either as a simple product term from the output of a single programmable AND array 22 or as a sum of products term from the output of an OR-gate summing a plurality of programmable AND arrays. Further, each I/O pin can be configured uniquely.

In Fig. 1, the common synchronous preset signal CMN SYN PRST and CMN ASYN RST signal are provided in common to all the registers (See Fig. 1) in the output register portions 16, the output macrocells 18, and the six buried register portions 20 of the programmable array logic device 10. The synchronous preset signal is dynamically provided as a product term from the output of programmable AND array on line 29b. As with the other dynamic control signals, the common synchronous preset CMN SYN PRST or asynchronous reset signal CMN ASYN RST can be implemented with other logic circuitry such as a sum-of-products term according to the present invention.

The function of the programmable array logic device 10 is enhanced by the dynamically provided control signals in conjunction with the six programmable fuses 32, 40, 54, 58, 63 and 72. The fusible link 32 of the device 10 of the instant invention can be set to determine whether the signal generated by XOR gate 30 is active HIGH or is active LOW and thus fuse 32 is referred to as the dedicated output register portion 16 polarity fuse. Fusible link 58 performs output polarity selection for the output macrocell 18.

The fusible links 40 and 72 can be set to determine whether the output enable control signals received by XOR gates 38 and 70, respectively, are to disable or enable the output buffers 34 and 60, respectively.

The fusible link 54 connected to MUX 50 can be set to determine whether the combinatorial signal at its 1D input or the registered signal at its 10 input will be conducted to the output polarity XOR gate 56. And the state of fusible link 63 connected to MUX 62 similarly determines whether the registered signal at its 1D input or the signal on the I/O pin 14 conducted to its 10 input is to be fedback to the AND array 22.

As the foregoing discussion illustrates, the function of the programmable array logic device 10 is greatly enhanced by the output logic circuits 16, 18 and 20
Further the output logic circuits can be utilized in a variety of integrated circuit devices to enchance the flexibility and dynamic control of the particular circuit implemented on the integrated circuit chip. In this manner the limitation occasioned by the relatively small number of input/output ports on a given integrated circuit chip with respect to the number of logic devices implemented on the chip can be minimized.

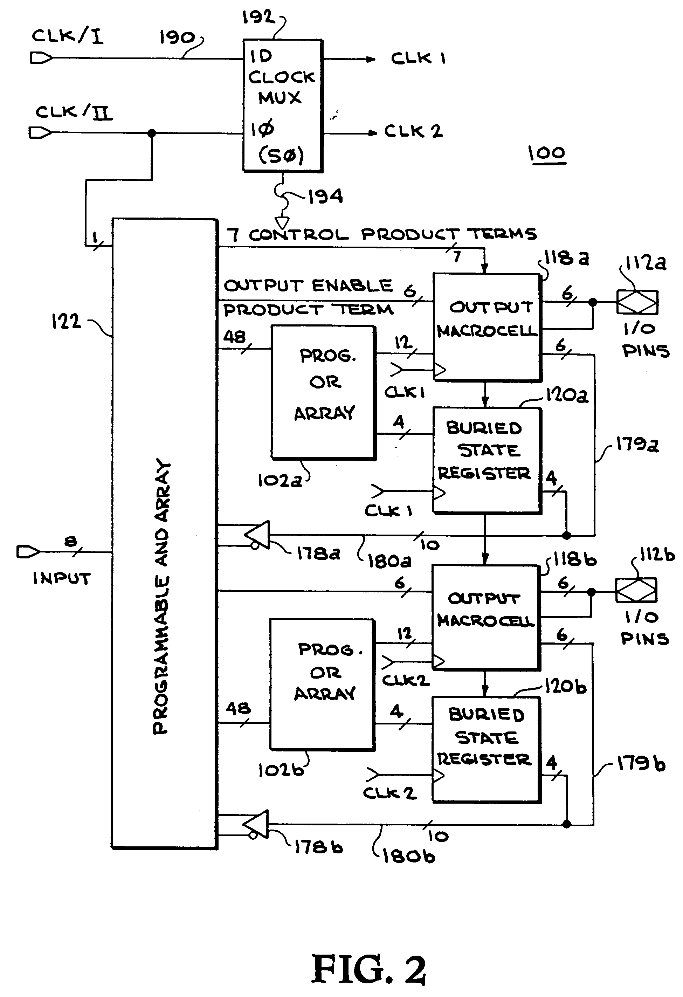

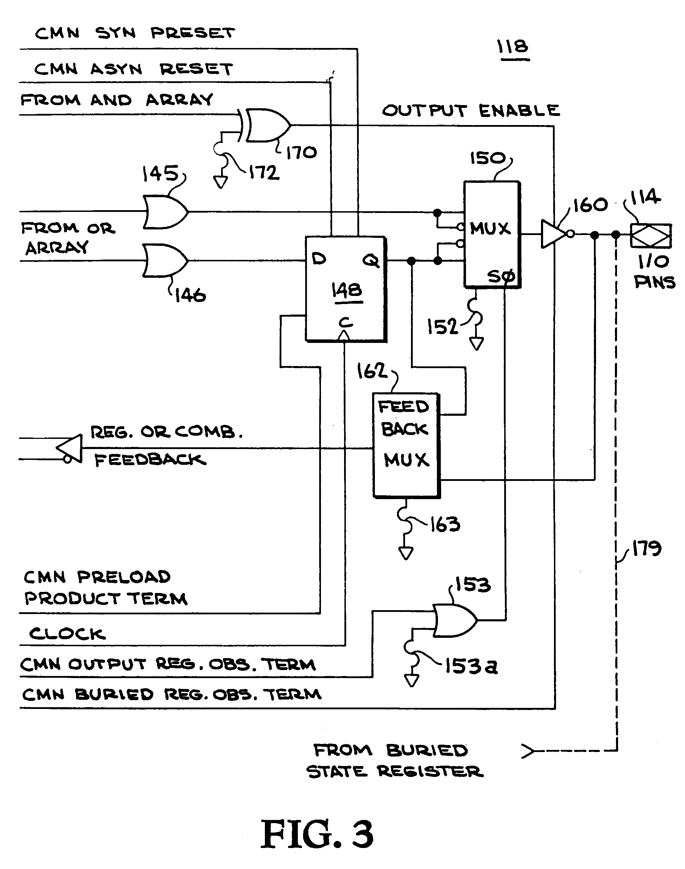

In Fig. 2 buried state registers and output macrocells similar to those shown in Fig. 1 are utilized in a programmable logic array (PLA) device 100. This employs a programmable AND array 122, similar to that shown in Fig. 1 as element 22, in conjunction with a pair of programmable OR arrays 102a and 102b. Each of the OR arrays receives from AND array 122, on a set of 48 signal lines, 48 "product term" signals and generates therefrom sixteen signals in an AND-OR (PLA) type of architecture. As this embodiment differs from that illustrated in Fig. 1 only in the employment of OR arrays, details of the output macrocells and in the clocking mechanism, many of the elements shown therein are omitted from Fig. 2 in the interest of clarity. The suffix "a" and "b" is used on Fig. 2 and its description when referring to elements forming a portion of an output macrocell 118a or of an output macrocell 118b, respectively, or of a buried state register portion 120a or a buried state register portion 120b, respectively. Reference numerals used in Figs. 2 and 3 are preceded by a "1" which indicate a like element in Fig. 1 not preceded by the "1".

A first bank of I/O pins, such as six, of which only one is shown 112a in Fig. 2, serve a first set of six, output macrocells 118a and a second bank of I/O pins, such as six, of which only one 112b is shown, serve a second set of six output macrocells 118b. A first set of four buried state register portions, of which only one 120a is shown, are associated with the OR array 102a and the output macrocells 118a, while a second set of four buried state register portions, of which only one 120b is shown, are associated with the OR array 102b and the output macrocells 118b.

Each buried state register portion 120a and 120b receives a signal from OR array 102a, 102b, respectively, in the same manner shown in Fig. 1 in which register 76 receives at its D input the signal generated by OR gate. Accordingly, each portion 120a and 120b comprises a register receiving the signal generated by an OR gate within OR array 102a, or 102b, respectively, and generates therefrom a signal at its Q output which is conducted back to AND array 122 on signal lines 180a and 180b, respectively, via buffers 178a and 178b, respectively. Similarly, the signals generated by the buried state registers 120a and 120b are conducted to the output macrocells 118a and 118b, respectively via signal lines 179a and 179b, respectively, where they may be observed at the I/O pins 112a and 112b, respectively, upon application of an OBSERVABILITY signal, as described above in connection with Fig. 1.

In all respects, the buried state register portions 120a and 120b illustrated in Fig. 2 are identical in structure and function with the buried state register portion 20 shown in Fig. 1 and, accordingly, will not be described in further detail. However, the output macrocells 118a and 118b differ in some respects from the output macrocell 18 illustrated in Fig. 1.

With reference to Fig. 3 which shows the preferred embodiment of the invention, an output macrocell 118, representative of macrocells 118a and 118b, of Fig. 2, receives both a first and a second signal from OR array 102a or 102b. The first such signal is conducted to the D input of a register 148, as is the case in the output macrocell 18 illustrated in Fig. 1. The second such signal is conducted to first true and complemented input terminal of an output and polarity select 4 to 1 multiplexer (MUX) 150. The Q output terminal of register 148 is connected to second true and complemented input of output select MUX 150. The output select MUX 150 of output macrocell 118 accordingly receives separate signals from the OR array to allow the user to pass either the first, combinatorial, signal directly from the OR array to the I/O pin or the second, registered, signal to the I/O pin. In the former case, the register behaves as a buried register. Provision of the separate signals from the OR array via OR gates 145 and 146 allow use of the register 148 of output macrocell 118 as another "buried" register, in the case where the combinatorial output signal on line 145 is selected by output select MUX 150, rather than the contents of register 148, to be conducted to I/O pin 114.

A common output register observability term signal is received at a first input to an output register observability control OR gate 153 which generates a signal which, in turn, is conducted to an SO output control terminal of MUX 150. A field-programmable fusible link 153a is connected to a second input of OR gate 153. Field-programmable fusible link 152 connected to MUX 150 provides a similar polarity control function described earlier in connection with MUX 50 of Fig. 1. A common buried register observability term signal is conducted to inverting output buffer 160.

The status of fuses 153a and 152 determine whether the registered or combinatorial signal will be conducted to I/O pin 114, and whether this signal so-conducted will be active HIGH or active LOW, respectively. With fuse 153a intact, the combinatorial signal is generated at pin 114, but the user can observe the contents of output register 148 at pin 114 by setting the common output register observability term signal HIGH. The user can observe the contents of the buried register 76 served by I/O pin 114 by setting the common buried register observability signal HIGH, thereby disabling output buffer 160, in the manner described earlier in connection with Fig. 1. In all other respects, the output macrocell 118 illustrated in Fig. 3 is identical in structure and function with the output macrocell 18 shown in Fig. 1, and accordingly, will not be described in further detail.

The contents of the buried state register portions 120a and 120b are conducted via lines 179a and 179b, respectively, to the output macrocells 118a and 118b, respectively, as shown on Fig. 2. A signal line 179, respresentative of lines 179a and 179b is shown on Fig. 3 as conducting the signal generated by the inverting buffer (82 on Fig. 1) serving the buried state register (76 on Fig. 1) to the I/O pin 114, in the same way as described in connection with Fig. 1.

As shown on Fig. 3 a common preload product term signal is received by register 148 from the AND array 122 which allows the user to set the state of register 148 during preliminary circuit verification when Zener voltages may not be available for this purpose. A common preload product term signal is also received by the buried state register portions 120a and 120b for preloading of these registers as well.

A first clock signal (CLK/I) applied to the integrated circuit package containing the PAL 100 is conducted on signal line 190 to a first input terminal of a fuse-programmable two-input, two-output clock multiplexer (CLK MUX) 192 a second clock signal (CLK/II) applied to PAL 100 is conducted to the second input terminal of CLK MUX 192 as well as to the programmable AND array 122. By appropriate programming of the field-programmable fuse 194 connected to a control select input (S0) of CLK MUX 192, the clock signals CLK1 and CLK2 generated at each of its outputs is either the CLK I or CLK II signal. The clock signal generated by MUX 192 at its first output, CLK1, is conducted to the register 148a of the first bank output macrocells 118a and to the register 176a of the buried state register portions 120a and the clock signal generated at its second output, CLK2, is conducted to the register 148b of the second bank output macrocells 118b and to the register 176b of the buried state register portions 120b. Furthermore, provision of fuse-programmable CLK MUX 192 allows the use of a common clock (CLK I) or different clocks CLK I and CLK II for each bank.

Another alternative embodiment to the PLA device shown in Fig. 2 is one in which a common clock is employed to provide the CLK1 and CLK2 signals received by the output macrocells 118a and 118b and the buried state registers 120a and 120b, employed in a single bank. In this single-bank alternative embodiment, the programmable OR array 102a is connected to the output macrocells 118a and 118b, rather than elements 118a and 120a, while the programmable OR array 102b is connected to the buried state register portions 120a and 120b, rather than elements 118b and 120b. These connections provide a separate output generation OR array 102a and a separate control sequencing OR array 102b so that the user can programmably specify dynamic control signals for the output macrocells 118a and 120a and independently specify control signals for the buried state register portions 120a and 120b.

The foregoing description of embodiments of the invention has been presented for purposes of illustration and description. They are not intended to be exhaustive or to limit the invention to the precise forms disclosed, and obviously many modifications and variations are possible in light of the above teaching. The programmable array logic device and the programmable logic array device embodiment are chosen and described in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A programmable logic device including:
a logic array (22,26,46,74) which is arranged to generate, from a number of input signals, a plurality of output signals which may be data signals and/or control signals,
a plurality of output cells (118) each comprising a storage cell (148) arranged to store a first data signal generated as a first array output by said logic array and present it at a cell output, and an input/output port (114)
characterised in that:
programmable means (150) is provided responsive to a first selection signal (S0) to selectively connect the input/output port (114) of an output cell (118) to either the output of the storage cell or to a second, separate, data signal generated as a second array output by said logic array.

2. A programmable logic device as claimed in Claim 1, characterised in that said programmable means comprises a multiplexer device (150) having one input connected to the output of the storage cell and a further input connected to receive said second data signal.

3. A programmable logic device as claimed in Claim 2, characterised in that said multiplexer device is responsive to a first control signal (CMN.OUTPUT REG.OBS. TERM) generated as an array output by said logic array, to selectively connect the output of said storage cell or said second data signal to said input/output port.

4. A programmable logic device as claimed in Claim 3 characterised in that first programmable means (153) is provided for selectively enabling said first control signal in response to a second selection signal.

5. A programmable logic device as claimed in Claim 4 characterised in said first programmable means comprises an OR gate (153), an input of which is connected to receive the first control signal and a second input of which is connected to receive the second selection signal.

6. A programmable logic device as claimed in any preceding claim, characterised in that an output buffer (160) is provided between said programmable means (150) and said input/output port (114), the output buffer being responsive to a second control signal generated as an output by said logic array as an enable signal.

7. A programmable logic device as claimed in Claim 6 characterised in that second programmable means (170) is provided to configure said second control signal to an active high or an active low mode in response to a third selection signal.

8. A programmable logic device as claimed in Claim 7, characterised in that said second programmable means (170) comprises an XOR gate (170), an input of which is connected to receive the second control signal (172) and a second input of which is connected to receive the third selection signal.

9. A programmable logic device as claimed in any preceding claim characterised by a further programmable multiplexer device (162) responsive to a fourth selection signal, having one input connected to said input/output port (114) and a further input connected to said storage cell output, and arranged to selectively connect either input to said logic array (22, 122).

10. A programmable logic device as claimed in any one of Claims 2 to 10, characterised in that the source of any one of said selection signals comprises a fusible link (152, 172, 153a, 163), the status of which determines that signal.

11. A programmable logic device as claimed in any preceding Claim, characterised in that said logic array is a programmable logic array.

## Patentansprüche

1. Programmierbare Logikvorrichtung mit:
- einer Logikanordnung (22, 26, 46, 74), die zum Erzeugen mehrerer Ausgangssignale, die Datensignale und/oder Steuersignale sein können, aus einer Zahl von Eingangssignalen ausgebildet ist,
- mehreren Ausgangszellen (118), von denen jede eine Speicherzelle (148), die zum Speichern eines von der Logikanordnung als erstes Anordnungsausgangssignal erzeugten ersten Datensignals und zum Anlegen desselben an einem Zellenausgang ausgebildet ist, und einen Eingangs-/Ausgangsport (114) aufweist,
dadurch gekennzeichnet, daß
- eine programmierbare Einrichtung (150) vorgesehen ist, die auf ein erstes Wählsignal (SO) reagiert, um den Eingangs-/Ausgangsport (114) einer Ausgangszelle (118) wahlweise entweder mit dem Ausgang der Speicherzelle oder mit einem zweiten, separaten Datensignal zu verbinden, das von der Logikanordnung als zweites Anordnungsausgangssignal erzeugt wird.

2. Programmierbare Logikvorrichtung nach Anspruch 1, dadurch gekennzeichnet, daß die programmierbare Einrichtung eine Multiplexervorrichtung (150) aufweist, wobei einer ihrer Eingänge mit dem Ausgang der Speicherzelle und ein weiterer Eingang zum Empfang des zweiten Datensignals verbunden ist.

3. Programmierbare Logikvorrichtung nach Anspruch 2, dadurch gekennzeichnet, daß die Multiplexervorrichtung auf ein von der Logikanordnung als Anordnungsausgangssignal erzeugtes erstes Steuersignal (CMN.OUTPUT REG.OBS. TERM) reagiert, um wahlweise den Ausgang der Speicherzelle oder das zweite Datensignal mit dem Eingangs-/Ausgangsport zu verbinden.

4. Programmierbare Logikvorrichtung nach Anspruch 3, dadurch gekennzeichnet, daß eine erste programmierbare Einrichtung (153) zum selektiven Freigeben des ersten Steuersignals in Reaktion auf ein zweites Wählsignal vorgesehen ist.

5. Programmierbare Logikvorrichtung nach Anspruch 4, dadurch gekennzeichnet, daß die erste programmierbare Einrichtung ein ODER-Gatter (153) aufweist, dessen einer Eingang zum Empfang des ersten Steuersignals und dessen zweiter Eingang zum Empfang des zweiten Wählsignals verbunden ist.

6. Programmierbare Logikvorrichtung nach einem der vorhergehenden Ansprüche, dadurch gekennzeichnet, daß zwischen der programmierbaren Einrichtung (150) und dem Eingangs-/Ausgangsport (114) ein Ausgangspuffer (160) vorgesehen ist, wobei der Ausgangspuffer auf ein von der Logikanordnung als Ausgangssignal erzeugtes zweites Steuersignal als Freigabesignal reagiert.

7. Programmierbare Logikvorrichtung nach Anspruch 6, dadurch gekennzeichnet, daß eine zweite programmierbare Einrichtung (170) vorgesehen ist, um das zweite Steuersignal in Reaktion auf ein drittes Wählsignal in einen aktiven High- oder aktiven Low-Modus zu konfigurieren.

8. Programmierbare Logikvorrichtung nach Anspruch 7, dadurch gekennzeichnet, daß die zweite programmierbare Einrichtung (170) ein XOR-Gatter (170) aufweist, dessen einer Eingang zum Empfang des zweiten Steuersignals (172) und dessen zweiter Eingang zum Empfang des dritten Wählsignals verbunden ist.

9. Programmierbare Logikvorrichtung nach einem der vorhergehenden Ansprüche, gekennzeichnet durch eine weitere programmierbare Multiplexervorrichtung (162), die auf ein viertes Wählsignal reagiert, wobei ein Eingang mit dem Eingangs-/Ausgangsport (114) und ein weiterer Eingang mit dem Speicherzellenausgang verbunden ist, und die wahlweise einen der beiden Eingänge mit der Logikanordnung (22, 122) verbindet.

10. Programmierbare Logikvorrichtung nach einem der Ansprüche 2 bis 10, dadurch gekennzeichnet, daß die Quelle eines jeden Wählsignals eine Schmelzsicherung (152, 172, 153a, 163) aufweist, deren Zustand das Signal bestimmt.

11. Programmierbare Logikvorrichtung nach einem der vorhergehenden Ansprüche, dadurch gekennzeichnet, daß die Logikanordnung eine programmierbare Logikanordnung ist.

## Revendications

1. Dispositif logique programmable comprenant:
un ensemble logique (22, 26, 46, 74) qui est configuré pour générer, à partir d'un certain nombre de signaux d'entrée, une pluralité de signaux de sortie qui peuvent être des signaux de données et/ou des signaux de commande,
une pluralité de cellules de sortie (118), chacune comportant une cellule de stockage (148) configurée pour stocker un premier signal de donnée généré, en tant que premier signal de sortie, par ledit ensemble logique et le présenter à une sortie de cellule, et un port d'entrée/sortie (114),
caractérisé en ce que:
un moyen programmable (150) sert, en réponse à un premier signal de sélection (S0), à connecter sélectivement le port d'entrée/sortie (114) d'une cellule de sortie (118) soit à la sortie de la cellule de stockage soit à un second signal de donnée distinct généré, en tant que second signal de sortie, par ledit ensemble logique.

2. Dispositif logique programmable selon la revendication 1, caractérisé en ce que ledit moyen programmable comporte un dispositif multiplexeur (150) ayant une entrée connectée à la sortie de la cellule de stockage et une autre entrée connectée de façon à recevoir ledit second signal de donnée.

3. Dispositif logique programmable selon la revendication 2, caractérisé en ce que ledit dispositif multiplexeur réagit à un premier signal de commande (CMN. OUTPUT REG. OBS. TERM) généré, en tant que signal de sortie, par ledit ensemble logique, pour connecter sélectivement la sortie de ladite cellule de stockage ou ledit second signal de donnée audit port d'entrée/sortie.

4. Dispositif logique programmable selon la revendication 3, caractérisé en ce qu'un premier moyen programmable (153) sert à valider sélectivement ledit premier signal de commande en réponse à un second signal de sélection.

5. Dispositif logique programmable selon la revendication 4, caractérisé en ce que ledit premier moyen programmable comporte une porte OU (153) dont une entrée est connectée de façon à recevoir le premier signal de commande et dont une seconde entrée est connectée de façon à recevoir le deuxième signal de sélection.

6. Dispositif logique programmable selon l'une quelconque des revendications précédentes, caractérisé en ce qu'un tampon de sortie (160) est placé entre ledit moyen programmable (150) et ledit port d'entrée/sortie (114), le tampon de sortie réagissant à un second signal de commande généré en sortie dudit ensemble logique en tant que signal de validation.

7. Dispositif logique programmable selon la revendication 6, caractérisé en ce qu'un second moyen programmable (170) sert à configurer ledit second signal de commande en mode actif haut ou en mode actif bas en réponse à un troisième signal de sélection.

8. Dispositif logique programmable selon la revendication 7, caractérisé en ce que ledit second moyen programmable (170) comporte une porte OU Exclusif (170) dont une entrée est connectée de façon à recevoir le second signal de commande (172) et dont une seconde entrée est connectée de façon à recevoir le troisième signal de sélection.

9. Dispositif logique programmable selon l'une quelconque des revendications précédentes, caractérisé par un dispositif multiplexeur supplémentaire (162) réagissant à un quatrième signal de sélection, ayant une entrée connectée audit port d'entrée/sortie (114) et une autre entrée connectée à la sortie de ladite cellule de stockage et configuré pour connecter sélectivement n'importe quelle entrée audit ensemble logique (22, 122).

10. Dispositif logique programmable selon l'une quelconque des revendications 2 à 9, caractérisé en ce que la source de n'importe lequel desdits signaux de sélection comporte une liaison fusible (152, 172, 153a, 163) dont l'état détermine ce signal.

11. Dispositif logique programmable selon l'une quelconque des revendications précédentes, caractérisé en ce que ledit ensemble logique est un ensemble logique programmable.
